# EUROPEAN PATENT SPECIFICATION

(11) **EP 4 181 400 B1**
(45) Date of publication and mention of the grant of the patent: **30.07.2025**
(21) Application number: 22207019.5
(22) Date of filing: 11.11.2022
(51) Int. Cl.: H03M 7/30, G01C 21/00, G01C 23/00

(54) **TOOL TO FACILITATE CUSTOMER GENERATED CHART DATABASES FOR USE WITH A CERTIFIED AVIONICS SYSTEM**
WERKZEUG ZUR ERMÖGLICHUNG VON KUNDENERZEUGTEN DIAGRAMMDATENBANKEN ZUR VERWENDUNG MIT EINEM ZERTIFIZIERTEN AVIONIKSYSTEM
OUTIL POUR FACILITER DES BASES DE DONNÉES GRAPHIQUES GÉNÉRÉES PAR LE CLIENT POUR UNE UTILISATION AVEC UN SYSTÈME AVIONIQUE CERTIFIÉ

(30) Priority: 12.11.2021 US 202163278576 P; 12.11.2021 US 202117525659
(43) Date of publication of application: 17.05.2023
(73) Proprietor: Rockwell Collins, Inc., Cedar Rapids, IA 52498 (US)
(72) Inventor: HENRY, Jeff M., Cedar Rapids, IA (US); PETERS, Kyle R., Cedar Rapids, IA (US); MILLER, Todd E., Marion, IA (US)
(74) Representative: Dehns

(56) References cited:
- EP-A1- 3 845 862
- US-A1- 2006 031 006
- US-A1- 2007 185 651

## Description

### BACKGROUND

Digital flight charts (i.e., aeronautical charts) are usually provided by third-party vendors in a format such as PDF and must be converted to an appropriate graphical format for use in flight displays. US2006031006A1 relates to a process for generating computer flight plans on the Internet. US2007185651A1 relates to a navigation system utilizing XML/SVG format map data converted from generally available geographic data and to a layered structure of the XML/SVG format map data created on the basis of administrative regions such as cities, counties, and states. EP3845862A1 relates to interactive charts.

### SUMMARY

The solution is provided by the features of the independent claims. Variations are as defined by the dependent claims.

It is to be understood that both the foregoing general description and the following detailed description are exemplary and explanatory only and are not necessarily restrictive of the invention as claimed. The accompanying drawings, which are incorporated in and constitute a part of the specification, illustrate embodiments of the invention and together with the general description, serve to explain the principles of the invention.

### BRIEF DESCRIPTION OF DRAWINGS

The numerous advantages of the disclosure may be better understood by those skilled in the art by reference to the accompanying figures in which:
FIGS. 1 and 2 are block diagrams illustrating the method steps of a flight chart conversion system, in accordance with one or more embodiments of the present disclosure.
FIG. 3 is a block diagram of a flight chart conversion system, in accordance with one or more embodiments of the present disclosure.
FIG. 4 is a flowchart illustrating a flight chart conversion method, in accordance with one or more embodiments of the present disclosure.

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the present disclosure, numerous specific details are set forth in order to provide a more thorough understanding of the inventive concepts. However, it will be apparent to one of ordinary skill in the art having the benefit of the present disclosure that the inventive concepts disclosed herein may be practiced without these specific details. In other instances, well-known features may not be described in detail to avoid unnecessarily complicating the present disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present). In addition, use of the "a" or "an" are employed to describe elements and components of embodiments of the present inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination or sub-combination of two or more such features, along with any other features which may not necessarily be expressly described or inherently present in the present disclosure.

Aeronautical charts (flight charts) are used by pilots to navigate aircraft during departing and landing phases (e.g., using terminal flight charts) and during en-route phases (e.g., using en-route flight charts). Using flight charts and other tools, pilots are able to determine position of the aircraft, safe altitudes for the aircraft, optimal routes to a destination, navigation aids, alternative landing areas in case of an inflight emergency, and other useful information such as radio frequencies and airspace boundaries. Specific charts are used for each phase of a flight and may vary from a map of a particular airport facility to an overview of the instrument routes covering an entire continent (e.g., global navigation charts).

Electronic chart data is conventionally defined in a digital file format such as portable data format (PDF) by flight chart vendors. Vendors that provide flight charts (e.g., to aircraft system manufacturers, airline pilots, etc.) in the PDF format provide the chart files at a lower cost than competitors. Flight chart users must convert the PDF flight charts to a format usable by aircraft computing devices (which are often limited in processing and memory capacity). Thus, it is desirable to provide a system that processes and converts flight charts such that aircraft computing devices can easily and efficiently retrieve flight chart data.

Embodiments of the present disclosure are directed to a flight chart conversion system that converts flight chart files to a condensed set of hardware directives that may be directly loaded onto aircraft computing devices. The converted flight charts are generated using software tools executed on a host computing device (e.g., a ground-based computing device that is not on the aircraft, such as a personal computer). The converted flight charts are then presented on an aircraft display using a flight chart application (executed using an aircraft computing device).

Flight chart files (graphical images of terminal and en-route charts) are processed on the host computing device into a set of binary images (e.g., images defined using 32-bit aircraft display hardware directives). The aircraft display hardware directives can then be quickly and easily displayed to a pilot. The aircraft display hardware directives may decrease loading times and conserve processing and memory resources. Flight chart metadata may also be generated to enable facile pilot selection and data lookup, and a configuration file may customize the chart conversion process for particular flight displays.

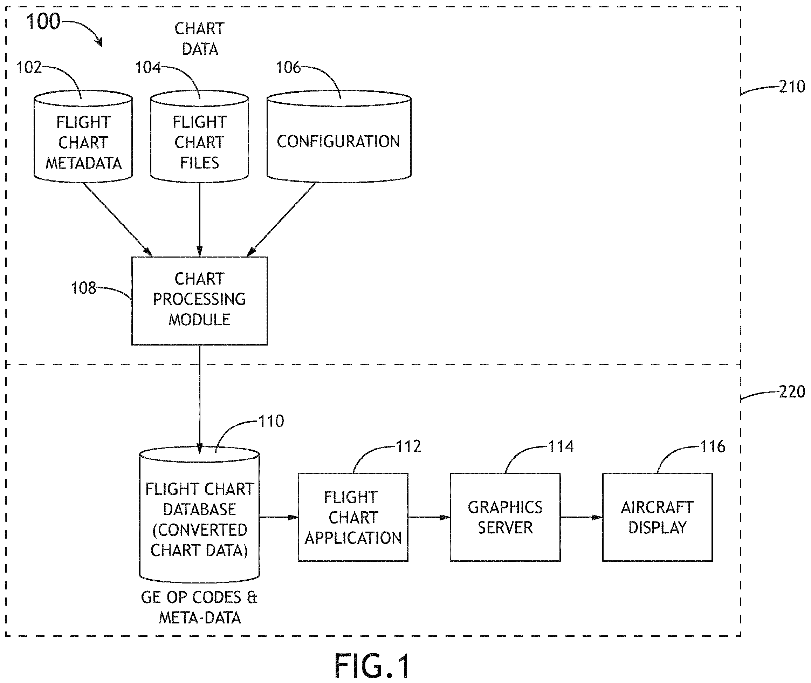

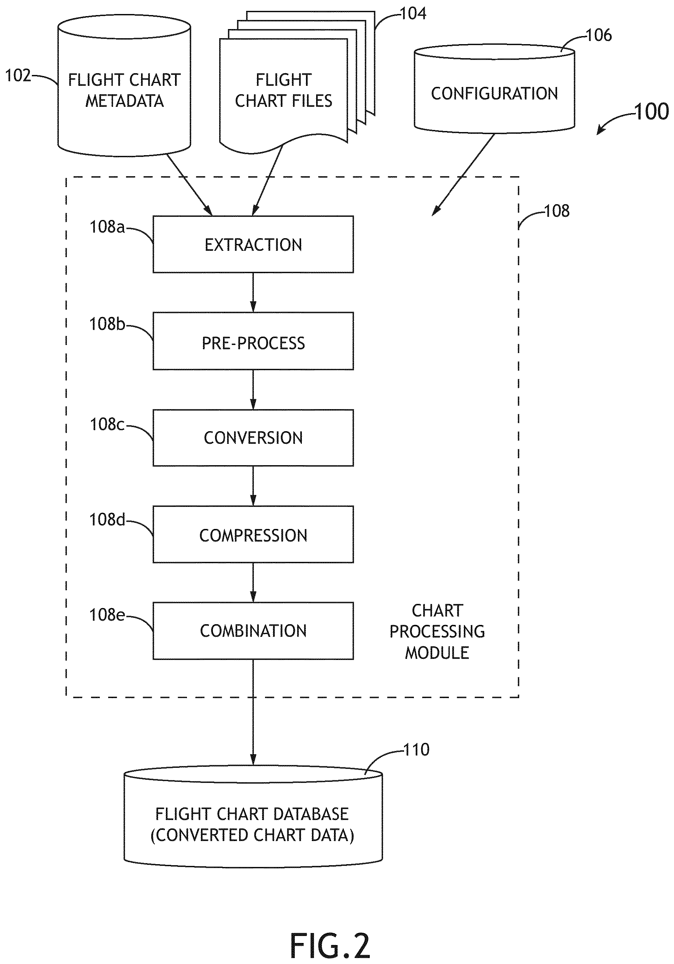

FIGS. 1 and 2 are block diagrams illustrating the method steps of a flight chart conversion system 100, in accordance with one or more embodiments of the present disclosure. The method steps of the flight conversion system 100 may be stored as program instructions (e.g., software modules) in a memory of one of more computing devices. A chart processing module 108 may be executed off-line 210 (e.g., not on an aircraft) using a host computing device to generate a flight chart database 110 (e.g., converted flight chart data) from one or more flight chart files 104. The flight chart database 110 may then be stored on a memory of an aircraft computing device and displayed to a pilot at run-time 220 (e.g., when the pilot operates an aircraft).

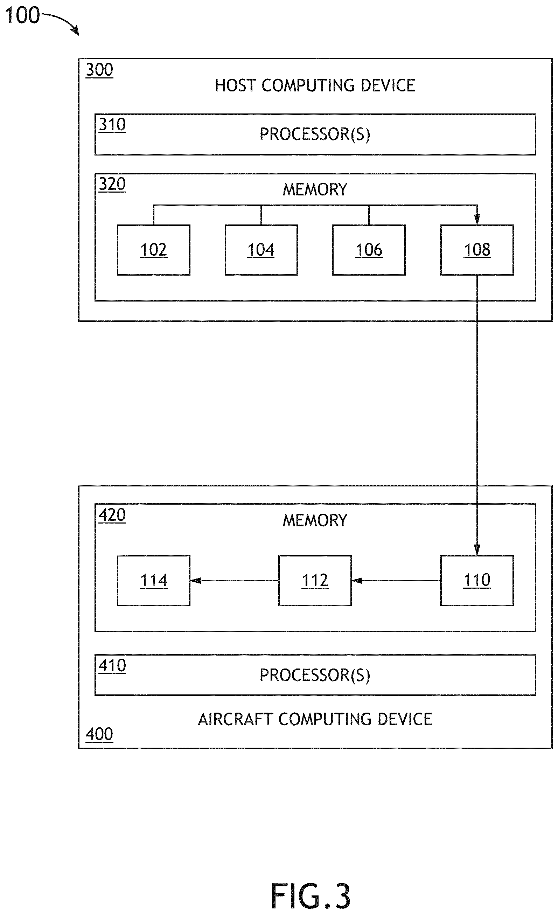

For example, FIG. 3 shows the flight conversion system 100 including a host computing device 300. Additionally, FIG. 3 shows an aircraft computing device 400 configured to display flight charts using the flight chart database 110 (e.g., after the conversion of the flight chart files 104 to the flight chart database 110).

The host computing device 300 and the aircraft computing device 400 may be controllers (e.g., computers), each respectively including one or more processors 310, 410 and a memory 320, 420. For the purposes of the present disclosure, the term "processor" or "processing element" may be broadly defined to encompass any device having one or more processing or logic elements, for example, one or more central processing units (CPUs), one or more graphics processing units (GPUs), one or more micro-processor devices, one or more application specific integrated circuit (ASIC) devices, one or more field programmable gate arrays (FPGAs), or one or more digital signal processors (DSPs), etc. In this sense, the one or more processors 310, 410 may include any device configured to execute algorithms and/or instructions (e.g., program instructions stored in memory), and may be configured to perform the method steps described in the present disclosure (for example, the method steps described with respect to FIGS. 1 and 2). The memories 320, 420 may include any storage medium known in the art suitable for storing program instructions executable by the associated processors 310, 410. For example, the memory mediums 320, 420 may include, but are not limited to, a read-only memory (ROM), a random-access memory (RAM), a magnetic or optical memory device (e.g., hard disk), a magnetic tape, a solid-state drive, and the like.

The host computing device 300 may be, for example, a personal computer (PC), a laptop, a smartphone, a tablet, a server, a mainframe, etc. In some embodiments, the host computing device may operate using a Microsoft^{®} Windows^{®} operating system, an Apple^{®} macOS^{®} operating system, a Linux-based operating system, etc. In some embodiments, the host computing device may comprise a plurality of computing devices (e.g., a cloud-based system). It is noted that the host computing device 300 may be a ground-based computing device (e.g., not a part of an aircraft).

The aircraft computing device(s) 400 may comprise one or more avionics embedded systems (e.g., an avionics suite), and may include a flight management system (FMS) computing device, a communications computing device, a navigation computing device, a flight display computing device, a flight control computing device, a fuel management computing device, a collision-avoidance computing device, a weather computing device, etc. It is noted that the host computing device 300 may have substantially greater processing and memory resources than the aircraft computing device(s) 400, and that it may be advantageous to implement the chart processing module 108 using the host computing device 300. For example, the flight chart files 104 required for a typical aircraft flight may have a size of 40 GB or more, whereas the memory 420 of the aircraft computing device 400 may have only 4 GB allocated to flight charts.

Referring back to FIG. 1, flight chart metadata 102, flight chart files 104, and a configuration file 106 may be input into the chart processing module 108 to generate a flight chart database 110. The metadata 102, flight chart files 104, and configuration file 106 may be stored on the memory 320 of the host computing device 300.

The flight chart file(s) 104 may be any industry standard flight chart file that includes text. In some embodiments, the flight chart files 104 may be portable data format (PDF) flight chart files, comma-separated values (CSV) flight chart files, or scalable vector graphics (SVG) flight chart files. The flight chart files 104 may be images representing terminal flight charts, en-route flight charts, nautical charts, world aeronautical charts, sectional charts, airport diagram charts, etc. The images may show topographical features such as terrain elevations, ground features identifiable from altitude (rivers, dams, bridges, buildings, airports, beacons, landmarks, etc.), and information related to airspace classes, ground-based navigation aids, radio frequencies, longitude and latitude, navigation waypoints, navigation routes, airways, taxiways, runways etc.

Each of the flight chart files 104 may be associated with respective flight chart metadata 102, which may include flight chart name (e.g., "Omaha Eppley Airfield"), flight chart type (e.g., terminal, en-route, world aeronautical, etc.), flight chart geographical location (e.g., Omaha, Nebraska), etc.

The metadata 102 may be defined in Extensible Markup Language (XML). XML is a markup language that defines a set of rules for encoding documents in a format that is both human-readable and machine-readable. The characters making up an XML document may be divided into markup and content, and may be distinguished by the application of syntactic rules. XML strings that constitute markup may begin with the character "<" and end with ">", or begin with the character "&" and end with ";". Strings of characters that are not markup are content. An XML tag may be a markup construct that begins with "<" and ends with ">". Three types of XML tags include: start-tag, such as <section>; end-tag, such as </section>; and empty-element tag, such as <line-break />. An XML element may be a logical document component that either begins with a start-tag and ends with a matching end-tag or includes only an empty-element tag. The characters between the start-tag and end-tag, if any, are the element's content, and may include markup and other elements, which are called child elements. An example is <greeting>Hello, world!</greeting>. Another is <line-break />. An XML attribute is a markup construct consisting of a name-value pair that exists within a start-tag or empty-element tag. An example is <flight_chart name="Omaha Eppley Airfield" type="terminal" location="Omaha, Nebraska"/>, where the names of the attributes are "name", "type", and "location" and their values are "Omaha Eppley Airfield", "terminal", and "Omaha, Nebraska" respectively. An XML attribute may have a single value and each attribute may appear once in each element.

The configuration file 106 may be used to define the type of aircraft display configured to display converted flight charts. For example, each type of aircraft display may have a respective resolution (e.g., 1920x1080), pixel density (e.g., 94 pixel per inch), aspect ratio (e.g., 16:9), and screen size (e.g., 22 inches diagonally) that differs from other types of aircraft displays. The configuration file 106 may also define input and output directories, version numbers, control data (e.g., an option to save temporary files), spatial modulation patterns of the aircraft display, and selection criteria (e.g., such that a pilot can search for a flight chart using a region name, a runway length, etc.). In some embodiments, the configuration file 106 is defined in XML. It is noted that the metadata 102 and the configuration file 106 may be defined in other data formats (for example, JavaScript Object Notation [JSON]).

Referring now to FIG. 2, a block diagram illustrating the method steps of the chart processing module 108 is shown. The chart processing module 108 may be stored in the memory 320 of the host computing device 300 and executed by the processor 310 of the host computing device 300. The chart processing module 108 may be substantially similar or substantially identical to the Electronic Chart Application Tool Suite developed by Collins Aerospace (Cedar Rapids, IA). The chart processing module 108 may include a plurality of submodules including an extraction module 108a, a preprocessing module 108b, a conversion module 108c, a compression module 108d, and a combination module 108e.

The extraction module 108a may be configured to convert the flight chart file(s) 104 to one or more scalable vector graphics (SVG) flight chart files defined in XML. In some embodiments, the SVG flight chart file(s) may be generated by converting PDF flight chart file(s) 104 or CSV flight chart file(s) 104. In some embodiments, the flight chart file(s) 104 may be SVG flight chart files, and the extraction module 108a may convert the original SVG flight chart file(s) 104 to SVG flight chart files having different tags.

SVG is a vector image format for two-dimensional graphics. Since the SVG flight chart file(s) are defined as XML text files, the SVG flight chart file(s) can be searched, compressed, and scaled in size without loss of quality. Each of the SVG flight chart file(s) may be associated with respective metadata 102 defined in XML (for example, in an element including a start-tag <metadata> and an end-tag </metadata>).

The preprocessing module 108b may be configured to preprocess the SVG flight chart file(s). Preprocessing the SVG flight chart file(s) may entail simplifying the SVG flight chart file(s) to improve the readability of flight chart(s) stored in the flight chart database 110, and to conserve the processing and memory resources of the aircraft computing device(s) 400 that access the flight chart database 110.

For example, the preprocessing module 108b may be configured to remove filled shapes overlapping navigational paths, fixes, and landmarks (to reduce clutter in the images), detect font characters and replace the font characters with font character references (so that all of the flight charts use the same font references when drawing characters which conserves memory capacity since the same font characters are not duplicated for each chart), associate charts with geographic references (e.g., airports, structures, landmarks, etc.), reduce the size of chart elements (to further conserve memory capacity), remove chart elements that are not visible (e.g., removing hidden chart elements to conserve memory capacity), detect repeating patterns (to further conserve memory capacity), and convert chart elements common to all of the flight charts to subroutines (to further conserve memory capacity).

The conversion module 108c may be configured to convert the SVG flight chart file(s) to one or more flight charts defined in one or more sets of aircraft display hardware directives. Each of the set(s) of aircraft display hardware directives is associated with the respective metadata 102. The aircraft display hardware directives may have a 32 bit form with 8 bits allocated to an opcode (e.g., that specifies a graphic operation to be performed, such as DRAW, MOVE, SETCOLOR) and 24 bits allocated to pixel data and pixel address (e.g., color of pixel(s), location of pixel(s), etc.).

The compression module 108d may be configured to compress each of the flight chart(s) and the respective metadata 102 (using a data compression algorithm). In this way, the compressed flight chart(s) use fewer bits than the original form, thus further conserving processing and memory resources of the computing devices 400. The compression may be either lossy or lossless. Lossless compression reduces bits by identifying and eliminating statistical redundancy (no information is lost in lossless compression). Lossy compression reduces bits by removing unnecessary or less important information

The combination module 108e may combine the flight chart(s) and the respective metadata 102 into a flight chart database 110 (converted chart data). The flight chart database 110 may then be loaded onto the memory 420 of the of the aircraft computing device(s) 400 via, for example, a satellite, cellular, or WiFi internet connection, a USB flash drive, a controller pilot data link (CPDL), etc.

After the flight chart database 110 is loaded onto the aircraft computing device(s) 400, a list of flight charts may populate the aircraft display 116, and the pilot or user of the aircraft may then highlight and select a flight chart to present on the aircraft display 116. The flight chart database 110 may be searchable using the respective associated metadata 102 of the flight chart. For example, the user of the aircraft may search for the name of the flight chart or the name of a geographic reference or chart element associated with the flight chart (e.g., by typing into a search bar presented on the aircraft display 116 using a keyboard or touchscreen).

The selected flight chart may then be passed to a chart application module 112. The chart application module 112 may render an image based on the selected flight chart using a graphics engine (GE) module. In some embodiments, the chart application module 112 may be substantially similar or substantially identical to the Electronic Charts Application (ECA) developed by Collins Aerospace (Cedar Rapids, IA), and the graphics engine module may be substantially similar or substantially identical to the Collins Graphics Engine developed by Collins Aerospace (Cedar Rapids, IA).

The set(s) of aircraft display hardware directives (associated with the selected flight chart) may be passed to a graphics server module 114 to be presented on one or more aircraft displays 116. The graphics server module 114 may be the interface (e.g., Cockpit Display System [CDS]) between the chart application module 112 and the aircraft display(s) 116. The graphics server module 114 may be an ARINC661 Graphics Server (AGS) that uses a Display List Data Widget to pass the set of aircraft display hardware directives to the aircraft display(s) 116. ARINC 661 may define communication between the graphics server module 114 and the chart application module 112 (i.e., an avionics computing standard). The graphics server module 114 manages one or more Definition Files (DFs) for the chart application module 112. The DFs specify the GUI definition associated with the chart application module 112 including one or more layers. A layer (also named User Application Layer Definition or UALD) is a GUI container for widgets, and a widget is the basic building block of the GUI (e.g., Containers, Lists, ScrollPanes, Buttons, Menus, Labels, EditBoxes, etc.).

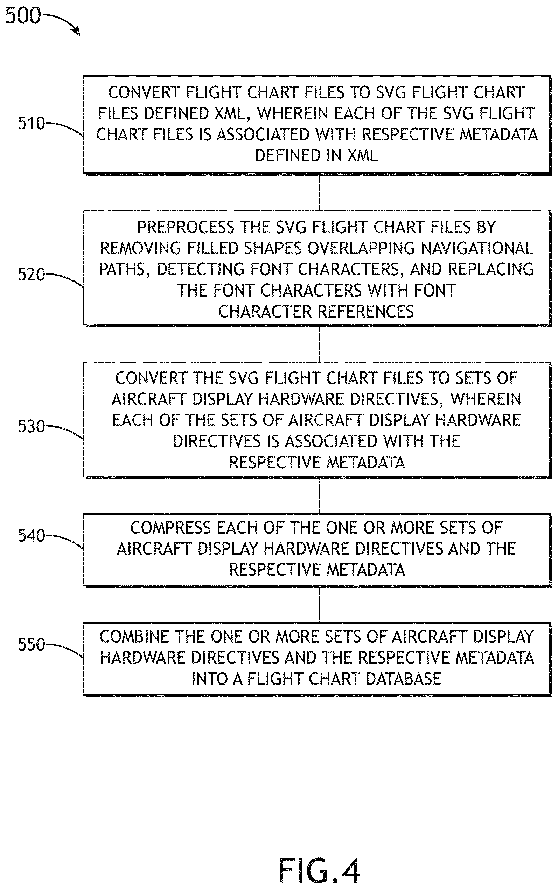

FIG. 4 is a flowchart illustrating a flight chart conversion method 500, in accordance with one or more embodiments of the present disclosure. The flight conversion method may be implemented by the flight conversion system 100 described with respect to FIGS. 1-3.

At step 510, flight chart file(s) are converted to SVG flight chart file(s) defined in XML. Each of the SVG flight chart file(s) may be associated with respective metadata defined in XML. At step 520, the SVG flight chart file(s) may be preprocessed by simplifying the SVG flight chart file(s) to improve the readability of flight charts, and to conserve the processing and memory resources of aircraft computing device(s) that utilize the flight charts. At step 530, each of the SVG flight chart file(s) may be converted to flight chart(s) defined in set(s) of aircraft display hardware directives. Each of the flight chart(s) is associated with the respective metadata. The aircraft display hardware directives may have a 32 bit form with 8 bits allocated to an opcode and 24 bits allocated to pixel data and pixel address. At step 540, each of the flight chart(s) and respective metadata may be compressed (e.g., using a data compression algorithm). At step 550, the flight chart(s) and the respective metadata may be combined into a flight chart database (e.g., converted chart data). The flight chart database may then be loaded onto the memory of the of the aircraft computing device(s).

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

## Claims

1. A flight chart conversion system (100), comprising:
a host computing device (300) including one or more processers (310) configured to execute program instructions causing the one or more processors to:
convert one or more portable data format, PDF, or comma-separated value (CSV), flight chart files to one or more scalable vector graphics, SVG, flight chart files defined in extensible markup language, XML, wherein the one or more PDF or CSV flight chart files are image files that show:
topographical features, including ground features available from altitude; and
information related to airspace classes, including radio frequencies,
wherein each of the SVG flight chart file(s) is associated with respective metadata defined in XML;
preprocess each of the SVG flight chart file(s), wherein preprocessing each of the SVS flight chart file(s) includes at least:
removing filled shapes overlapping navigational paths, detecting font characters, and replacing the font characters with font character references;
convert the SVG flight chart file(s) to one or more flight charts defined in one or more sets of aircraft display hardware directives, wherein each of the flight chart(s) is associated with the respective metadata;
compress the flight chart(s) and the respective metadata; and
combine the flight chart(s) and the respective metadata into a flight chart database.

2. The flight chart conversion system (100) of claim 1, wherein an aircraft computing device (400) includes one or more processers (410) configured to execute program instructions causing the one or more processors to:
display the flight chart(s) on an aircraft display using at least one of the set(s) of aircraft display hardware directives.

3. The flight chart conversion system (100) of claim 2, wherein each of the flight chart(s) corresponds to a respective one of the set(s) of aircraft display hardware directives.

4. The flight chart conversion system (100) of claim 2 or 3, wherein the flight chart(s) are associated with a configuration file that defines a resolution, an aspect ratio, and a pixel density of the aircraft display.

5. The flight chart conversion system (100) of any preceding claim, wherein the flight chart file(s) are images representing a terminal flight chart, an en-route flight chart, a nautical flight chart, a world aeronautical flight chart, or a sectional flight chart.

6. The flight chart conversion system (100) of any preceding claim, wherein the respective metadata includes at least one of:
a flight chart name, and
a flight chart type.

7. The flight chart conversion system (100) of claim 6, wherein each of the flight chart(s) is indexed in the flight chart database by the flight chart name and the flight chart type included in the respective metadata.

8. A flight chart conversion method (500), comprising: using a host computing device,
converting (510) one or more portable data file, PDF, or comma-separated value (CSV), flight chart files to one or more scalable vector graphics, SVG flight chart files defined in extensible markup language, XML, wherein the one or more PDF or CSV flight chart files are image files that show:
topographical features, including ground features available from altitude; and
information related to airspace classes, including radio frequencies,
wherein each of the SVG flight chart file(s) is associated with respective metadata defined in XML;
preprocessing (520) each of the SVG flight chart file(s), wherein preprocessing each of the SVS flight chart file(s) includes at least: removing filled shapes overlapping navigational paths, detecting font characters, and replacing the font characters with font character references;
converting (530) the SVG flight chart file(s) to one or more flight charts defined in one or more sets of aircraft display hardware directives, wherein each of the flight chart(s) is associated with the respective metadata;
compressing (540) the flight chart(s) and the respective metadata; and
combining (550) the flight chart(s) and the respective metadata into a flight chart database.

9. The flight chart conversion method (500) of claim 8, comprising:
using an aircraft computing device, displaying the flight chart(s) on an aircraft display using at least one of the set(s) of aircraft display hardware directives.

10. The flight chart conversion method (500) of claim 9, wherein the flight chart(s) are associated with a configuration file that defines a resolution, an aspect ratio, and a pixel density of the aircraft display.

11. The flight chart conversion method (500) of any of claims 8 to 10, wherein the one or more flight chart files are images representing a terminal flight chart, an en-route flight chart, a nautical flight chart, a world aeronautical flight chart, or a sectional flight chart.

12. The flight chart conversion method (500) of any of claims 8 to 11, wherein the respective metadata includes at least one of:
a flight chart name, and
a flight chart type.

13. The flight chart conversion method of claim 12, wherein each of the flight chart(s) is indexed in the flight chart database by the flight chart name and the flight chart type included in the respective metadata.

## Patentansprüche

1. Flugdiagramm-Umwandlungssystem (100), umfassend:
eine Host-Rechenvorrichtung (300), die einen oder mehrere Prozessoren (310) beinhaltet, die dazu konfiguriert sind, Programmanweisungen auszuführen, die den einen oder die mehreren Prozessoren zu Folgendem veranlassen:
Umwandeln eines oder mehrerer tragbarer Datenformate (portable data format, PDF) oder durch kommagetrennte Werte (comma-separated value, CSV) in Flugdiagrammdateien in eine oder mehrere skalierbare Vektorgrafiken-(scalable vector graphics, SVG-)Flugdiagrammdateien, die in einer erweiterbaren Auszeichnungssprache (extensible markup language, XML) definiert sind, wobei die eine oder mehreren PDF- oder CSV-Flugdiagrammdateien Bilddateien sind, die Folgendes zeigen:
topografische Merkmale, einschließlich Bodenmerkmale, die aus der Höhe verfügbar sind; und
Informationen, die sich auf Luftraumklassen beziehen, einschließlich Funkfrequenzen,
wobei jede (der) SVG-Flugdiagrammdatei(en) jeweiligen Metadaten zugeordnet ist, die in XML definiert sind;
Vorverarbeiten jeder (der) SVG-Flugdiagrammdatei(en), wobei das Vorverarbeiten jeder (der) SVS-Flugdiagrammdatei(en) mindestens Folgendes beinhaltet:
Entfernen gefüllter Formen, die Navigationspfade überlappen, Detektieren von Schriftzeichen und Ersetzen der Schriftzeichen durch Schriftzeichenreferenzen;
Umwandeln der SVG-Flugdiagrammdatei (en) in ein oder mehrere Flugdiagramme, die in einem oder mehreren Sätzen von Luftfahrzeug-Anzeigehardwareanweisungen definiert sind, wobei jedes (der) Flugdiagramm(e) den jeweiligen Metadaten zugeordnet ist;
Komprimieren des(der) Flugdiagramms (e) und der jeweiligen Metadaten; und
Kombinieren des (der) Flugdiagramms(e) und der jeweiligen Metadaten zu einer Flugdiagrammdatenbank.

2. Flugdiagramm-Umwandlungssystem (100) nach Anspruch 1, wobei eine Luftfahrzeug-Rechenvorrichtung (400) einen oder mehrere Prozessoren (410) beinhaltet, die dazu konfiguriert sind, Programmanweisungen auszuführen, die den einen oder die mehreren Prozessoren zu Folgendem veranlassen:
Anzeigen des(der) Flugdiagramms(e) auf einer Luftfahrzeug-Anzeige unter Verwendung mindestens eines von dem Satz (den Sätzen) von Luftfahrzeug-Anzeigehardwareanweisungen.

3. Flugdiagramm-Umwandlungssystem (100) nach Anspruch 2, wobei jedes des (der) Flugdiagramms (e) einem jeweiligen des Satzes (der Sätze) von Luftfahrzeug-Anzeigehardwareanweisungen entspricht.

4. Flugdiagramm-Umwandlungssystem (100) nach Anspruch 2 oder 3, wobei das (die) Flugdiagramm(e) einer Konfigurationsdatei zugeordnet ist/sind, die eine Auflösung, ein Aspektverhältnis und eine Pixeldichte der Luftfahrzeug-Anzeige definiert.

5. Flugdiagramm-Umwandlungssystem (100) nach einem der vorhergehenden Ansprüche, wobei die Flugdiagrammdatei (en) Bilder sind, die ein Terminalflugdiagramm, ein Streckenflugdiagramm, ein nautisches Flugdiagramm, ein weltweites aeronautisches Flugdiagramm oder ein Sektionsflugdiagramm darstellen.

6. Flugdiagramm-Umwandlungssystem (100) nach einem der vorhergehenden Ansprüche, wobei die jeweiligen Metadaten mindestens eines von Folgendem beinhalten:
einen Flugdiagrammnamen und
einen Flugdiagrammtyp.

7. Flugdiagramm-Umwandlungssystem (100) nach Anspruch 6, wobei jedes (der) Flugdiagramm(e) in der Flugdiagrammdatenbank durch den Flugdiagrammnamen und den Flugdiagrammtyp indexiert ist, die in den jeweiligen Metadaten beinhaltet sind.

8. Flugdiagramm-Umwandlungsverfahren (500), umfassend:
unter Verwendung einer Host-Rechenvorrichtung,
Umwandeln (510) einer oder mehrerer tragbaren Datendateien, PDF, oder durch kommagetrennte Werte (CSV) in Flugdiagrammdateien in eine oder mehrere skalierbare Vektorgrafiken-, SVG-, Flugdiagrammdateien, die in einer erweiterbaren Auszeichnungssprache, XML, definiert sind, wobei die eine oder mehreren PDF- oder CSV-Flugdiagrammdateien Bilddateien sind, die Folgendes zeigen:
topografische Merkmale, einschließlich Bodenmerkmale, die aus der Höhe verfügbar sind; und
Informationen, die sich auf Luftraumklassen beziehen, einschließlich Funkfrequenzen,
wobei jede (der) SVG-Flugdiagrammdatei(en) jeweiligen Metadaten zugeordnet ist, die in XML definiert sind;
Vorverarbeiten (520) jeder (der) SVG-Flugdiagrammdatei(en), wobei das Vorverarbeiten jeder (der) SVS-Flugdiagrammdatei(en) mindestens Folgendes beinhaltet: Entfernen gefüllter Formen, die Navigationspfade überlappen, Detektieren von Schriftzeichen und Ersetzen der Schriftzeichen durch Schriftzeichenreferenzen;
Umwandeln (530) der SVG-Flugdiagrammdatei(en) in ein oder mehrere Flugdiagramme, die in einem oder mehreren Sätzen von Luftfahrzeug-Anzeigehardwareanweisungen definiert sind, wobei jedes (der) Flugdiagramm(e) den jeweiligen Metadaten zugeordnet ist;
Komprimieren (540) des(der) Flugdiagramms(e) und der jeweiligen Metadaten; und
Kombinieren (550) des(der) Flugdiagramms(e) und der jeweiligen Metadaten zu einer Flugdiagrammdatenbank.

9. Flugdiagramm-Umwandlungsverfahren (500) nach Anspruch 8, umfassend:
unter Verwendung einer Luftfahrzeug-Rechenvorrichtung Anzeigen des(der) Flugdiagramms(e) auf einer Luftfahrzeug-Anzeige unter Verwendung mindestens eines von dem Satz (den Sätzen) von Luftfahrzeug-Anzeigehardwareanweisungen.

10. Flugdiagramm-Umwandlungsverfahren (500) nach Anspruch 9, wobei das(die) Flugdiagramm(e) einer Konfigurationsdatei zugeordnet ist/sind, die eine Auflösung, ein Aspektverhältnis und eine Pixeldichte der Luftfahrzeug-Anzeige definiert.

11. Flugdiagramm-Umwandlungsverfahren (500) nach einem der Ansprüche 8 bis 10, wobei die eine oder die mehreren Flugdiagrammdateien Bilder sind, die ein Terminalflugdiagramm, ein Streckenflugdiagramm, ein nautisches Flugdiagramm, ein weltweites aeronautisches Flugdiagramm oder ein Sektionsflugdiagramm darstellen.

12. Flugdiagramm-Umwandlungsverfahren (500) nach einem der Ansprüche 8 bis 11, wobei die jeweiligen Metadaten mindestens eines von Folgendem beinhalten:
einen Flugdiagrammnamen und
einen Flugdiagrammtyp.

13. Flugdiagramm-Umwandlungsverfahren nach Anspruch 12, wobei jedes (der) Flugdiagramm(e) in der Flugdiagrammdatenbank durch den Flugdiagrammnamen und den Flugdiagrammtyp indexiert ist, die in den jeweiligen Metadaten beinhaltet sind.

## Revendications

1. Système de conversion de cartes de vol (100), comprenant :
un dispositif informatique hôte (300) comportant un ou plusieurs processeurs (310) configurés pour exécuter des instructions de programme amenant les un ou plusieurs processeurs à :
convertir un ou plusieurs fichiers de cartes de vol au format de données portable, PDF, ou au format de valeurs séparées par une virgule (CSV) en un ou plusieurs fichiers de cartes de vol au format graphique vectoriel adaptable, SVG, définis dans un langage de balisage extensible, XML, dans lequel les un ou plusieurs fichiers de cartes de vol PDF ou CSV sont des fichiers d'image représentant :
des caractéristiques topographiques, comportant des caractéristiques du sol visibles en altitude ; et
des informations relatives aux classes d'espace aérien, comportant des fréquences radio,
dans lequel chacun du ou des fichiers de cartes de vol SVG est associé à des métadonnées respectives définies en XML ;
prétraiter chacun du ou des fichiers de cartes de vol SVG, dans lequel le prétraitement de chacun du ou des fichiers de cartes de vol SVS comporte au moins :
la suppression de formes remplies chevauchant des chemins de navigation, la détection de caractères de police, et le remplacement des caractères de police par des références aux caractères de police ;
convertir le ou les fichiers de cartes de vol SVG en une ou plusieurs cartes de vol définies dans un ou plusieurs ensembles de directives matérielles d'affichage d'aéronef, dans lequel chacune de la ou des cartes de vol est associée aux métadonnées respectives ;
compresser la ou les cartes de vol et les métadonnées respectives ; et
combiner la ou les cartes de vol et les métadonnées respectives dans une base de données de cartes de vol.

2. Système de conversion de cartes de vol (100) selon la revendication 1, dans lequel un dispositif informatique d'aéronef (400) comporte un ou plusieurs processeurs (410) configurés pour exécuter des instructions de programme amenant le ou les processeurs à :
afficher la ou les cartes de vol sur un affichage d'aéronef à l'aide d'au moins l'un du ou des ensembles de directives matérielles d'affichage d'aéronef.

3. Système de conversion de cartes de vol (100) selon la revendication 2, dans lequel chacune de la ou des cartes de vol correspond à un ensemble respectif parmi le ou les ensembles des directives matérielles d'affichage d'aéronef.

4. Système de conversion de cartes de vol (100) selon la revendication 2 ou 3, dans lequel la ou les cartes de vol sont associées à un fichier de configuration qui définit une résolution, un rapport d'aspect, et une densité de pixels de l'affichage d'aéronef.

5. Système de conversion de cartes de vol (100) selon l'une quelconque revendication précédente, dans lequel le ou les fichiers de cartes de vol sont des images représentant une carte de vol terminale, une carte de vol en route, une carte de vol nautique, une carte de vol aéronautique mondiale, ou une carte de vol en coupe.

6. Système de conversion de cartes de vol (100) selon l'une quelconque revendication précédente, dans lequel les métadonnées respectives comportent au moins l'un des éléments suivants :
un nom de carte de vol, et
un type de carte de vol.

7. Système de conversion de cartes de vol (100) selon la revendication 6, dans lequel chacune de la ou des cartes de vol est indexée dans la base de données de cartes de vol par le nom de carte de vol et le type de carte de vol inclus dans les métadonnées respectives.

8. Procédé de conversion de carte de vol (500), comprenant :
à l'aide d'un dispositif informatique hôte,
la conversion (510) d'un ou plusieurs fichiers de cartes de vol au format de données portable, PDF, ou au format de valeurs séparées par une virgule (CSV) en un ou plusieurs fichiers de cartes de vol au format graphique vectoriel adaptable, SVG, définis dans un langage de balisage extensible, XML, dans lequel les un ou plusieurs fichiers de cartes de vol PDF ou CSV sont des fichiers d'image représentant :
des caractéristiques topographiques, comportant des caractéristiques du sol visibles en altitude ; et
des informations relatives aux classes d'espace aérien, comportant des fréquences radio,
dans lequel chacun du ou des fichiers de cartes de vol SVG est associé à des métadonnées respectives définies en XML ;
le prétraitement (520) de chacun du ou des fichiers de cartes de vol SVG, dans lequel le prétraitement de chacun du ou des fichiers de cartes de vol SVS comporte au moins : la suppression de formes remplies chevauchant des chemins de navigation, la détection de caractères de police, et le remplacement des caractères de police par des références aux caractères de police ;
la conversion (530) du ou des fichiers de cartes de vol SVG en une ou plusieurs cartes de vol définies dans un ou plusieurs ensembles de directives matérielles d'affichage d'aéronef, dans lequel chacune de la ou des cartes de vol est associée aux métadonnées respectives ;
la compression (540) de la ou des cartes de vol et des métadonnées respectives ; et
la combinaison (550) de la ou des cartes de vol et des métadonnées respectives dans une base de données de cartes de vol.

9. Procédé de conversion de carte de vol (500) selon la revendication 8, comprenant :
à l'aide d'un dispositif informatique d'aéronef, l'affichage de la ou des cartes de vol sur un affichage d'aéronef à l'aide d'au moins l'un du ou des ensembles de directives matérielles d'affichage d'aéronef.

10. Procédé de conversion de cartes de vol (500) selon la revendication 9, dans lequel la ou les cartes de vol sont associées à un fichier de configuration qui définit une résolution, un rapport d'aspect, et une densité de pixels de l'affichage d'aéronef.

11. Procédé de conversion de cartes de vol (500) selon l'une quelconque des revendications 8 à 10, dans lequel le ou les fichiers de cartes de vol sont des images représentant une carte de vol terminale, une carte de vol en route, une carte de vol nautique, une carte de vol aéronautique mondiale, ou une carte de vol en coupe.

12. Procédé de conversion de carte de vol (500) selon l'une quelconque des revendications 8 à 11, dans lequel les métadonnées respectives comportent au moins l'un des éléments suivants :
un nom de carte de vol, et
un type de carte de vol.

13. Procédé de conversion de cartes de vol selon la revendication 12, dans lequel chacune de la ou des cartes de vol est indexée dans la base de données de cartes de vol par le nom de carte de vol et le type de carte de vol inclus dans les métadonnées respectives.
